# EUROPÄISCHE PATENTSCHRIFT

(11) **EP 0 669 697 B1**
(45) Veröffentlichungstag und Bekanntmachung des Hinweises auf die Patenterteilung: **17.12.1997**
(21) Anmeldenummer: 95100281.5
(22) Anmeldetag: 11.01.1995
(51) Int. Cl.: H02K 7/14, A47J 43/07

(54) **Gehäuse für ein elektrisch betriebenes Gerät des persönlichen Bedarfs**
Housing for electric appliance for personal use
Boîtier d'un appareil électrique à usage personnel

(30) Priorität: 23.02.1994 DE 4405765
(43) Veröffentlichungstag der Anmeldung: 30.08.1995
(73) Patentinhaber: Braun Aktiengesellschaft, Frankfurt am Main (DE)
(72) Erfinder: Golob, Jürgen, D-61381 Friedrichsdorf (DE); Rebordosa, Antonio, E-08240 Manresa (Barcelona) (ES)

(56) Entgegenhaltungen:
- CH-A- 426 145
- DE-A- 2 739 137
- DE-U- 1 790 734
- FR-A- 2 195 102
- GB-A- 2 020 216
- GB-A- 2 116 154
- US-A- 5 247 218
- DATABASE WPI Week 8706 Derwent Publications Ltd., London, GB; AN 87-040890 & JP-A-62 000 340 (MOLTEN KK, FORBRAY KK), 6 Januar 1987
- DESIGN ENGINEERING, September 1983 LONDON, Seite 19 A. PYE 'High-grip finish achieved by co-injection moulding'
- DATABASE WPI Week 8735 Derwent Publications Ltd., London, GB; AN 87-245809 & JP-A-62 167 048 (SHOWA DENKO KK), 23 Juli 1987
- DATABASE WPI Week 8644 Derwent Publications Ltd., London, GB; AN 86-289272 & JP-A-61 213 145 (SHIINA F), 22 September 1986

## Beschreibung

Die Erfindung betrifft ein Gehäuse für ein elektrisch betriebenes Gerät des persönlichen Bedarfs, wie Zahnbürste, Rasierapparat, Küchengerät oder -maschine und dergleichen zur Aufnahme von Antriebs-, Steuer- und Schalteinrichtungen, das aus einem ersten Kunststoff mit mindestens einer Außenfläche und einer Innenfläche besteht und das zumindest in einem Bereich mit wenigstens einem zweiten Kunststoff, dessen Härte geringer ist als die Härte des ersten Kunststoffes, versehen ist.

Derartige Gehäuse sind bereits bekannt und werden insbesondere als Gehäusewand für Geräte des persönlichen Bedarfs, wie Elektrorasierer, Filmkameras, elektrische Zahnbürsten oder dergleichen eingesetzt (siehe FR-A-2 195 102 und GB-A-2 020 216). Beispielsweise in der DE-A-27 39 137 ist bereits eine perforierte Gehäusewand beschrieben, bei der eine Folie auf die Innenfläche der Gehäusewand z. B. aufgeklebt ist, wobei diese Folie oder Platte aus einem Kunststoff oder anderem gummiähnlichen Werkstoff, z. B. Elastomer, besteht. Die Folie ist einseitig mit einer Vielzahl von über eine Fläche der Folie oder der Platte vorstehenden Noppen oder zungenartigen Vorsprüngen versehen, die nach Lage, Zahl und Größe so angeordnet sind, daß sie sich durch die Perforationen der Gehäusewand hindurch erstrecken und um ein Geringes über die Außenfläche des Gehäuses hervorstehen.

Hierbei ist die perforierte Gehäusewand ein Kunststoff-Spritzgußteil, bestehend aus einem Kunststoff mit anderen Eigenschaften als der Kunststoff der Folie oder Platte. Obwohl sich derartige Gehäuse im praktischen Gebrauch weitgehend durchgesetzt haben, sind Herstellungsaufwand und Fertigungskosten derartiger Gehäuse, die bevorzugt in Massenproduktion hergestellt werden, sehr hoch.

Auch sind die für die Herstellung derartiger Gehäuse erforderlichen Spritzgußwerkzeuge aufwendig und kostspielig.

Weiterhin ist aus der DE-A-43 06 588 eine schwingungsdämpfende Halterung für einen Elektromotor in einem Gehäuse bekannt, bei dem sich die Halterung aus auf Haltestegen aufgeschobenen Dämpfungselementen ergibt. Diese Dämpfungselemente bestehen aus separat hergestellten Gummiteilen, die in einem verhältnismäßig aufwendigen Montagevorgang auf das Motorgehäuse aufgeschoben werden müssen.

Aufgabe der Erfindung ist es, ein Gehäuse für ein elektrisch betriebenes Gerät des persönlichen Bedarfs zu schaffen, das bei geringen Herstellkosten und hoher Gestaltungsfreiheit besonders einfach herstellbar ist und durch das weitere Bauteile auf einfache Weise zentriert, gehalten und schwingungsgedämpft gelagert werden, ohne daß zusätzliche, in das Gehäuse einsetzbare Bauteile hierfür benötigt werden.

Diese Aufgabe wird nach den Merkmalen des Patentanspruchs 1 gelöst. Nach dem Ausformen des aus einem ersten Kunststoff bestehenden Gehäuses wird dieses nach der Erfindung in einem zweiten Werkzeug mit einem zweiten Kunststoff, welcher in seiner Härte geringer ist als der erste Kunststoff, an den Stellen überspritzt, die später als Anlage, als reibschlüssiger oder dichter Halt für im Gehäuse nachträglich zu montierende Bauteile dienen. Durch diese einfache Gehäuseherstellung werden diese Bauteile im Gehäuse dämpfend und spielfrei gelagert, wobei dabei diese Bauteile so bemessen sind, daß sie mit einer gewissen Vorspannung gegen die Außenfläche der Anlagebereiche gedrückt werden. Durch die elastische Lagerung der Bauteile werden diese im Gehäuse schwingungsgedämpft gelagert und zentriert, ohne daß zusätzliche Befestigungsmittel benötigt werden. Dies ist insbesondere dann von Vorteil, wenn das Gehäuse aus einem im wesentlichen kreiszylindrischen Querschnitt besteht, in dessen Öffnung die Bauteile eingesetzt und so durch den elastischen zweiten Kunststoff derart vorgespannt werden, daß sie im Gehäuse ortsfest und schwingungsdämpfend gehalten werden. Unter dem zweiten Kunststoff im Sinne der Erfindung ist zu verstehen, daß auch verschiedene Kunststoffe mit verschiedenen Härten, Farben, etc., am ersten Kunststoff des Gehäuses angespritzt werden können, allerdings sind die verschiedenen Bereiche dann nicht miteinander verbunden.

Die Anlagebereiche und ihre Verbindungsbereiche können zusätzlich auch noch der Schalldämmung dienen oder aber auch als Lichtschirm wirken, wodurch verhindert wird, daß in dem Gehäuse vorgesehene Signallampen neben dem Sichtfenster durch das Gehäuse scheinen. Auch können diese Bereiche als Federelement zum elastischen Abstützen von Einbauteilen innerhalb des Gehäuses dienen. Hierdurch wird die Stoßfestigkeit des Gerätes erhöht, ein Ausgleich von Toleranzen und Wärmedehnungen ermöglicht und die Übertragung von Vibrationen vermindert. Die einzelnen Bereiche auf der Außenfläche, die mit dem zweiten Kunststoff versehen sind, sind über die Durchbrechungen und die auf der Innenfläche vorhandenen Verbindungsbereiche, die ebenfalls mit dem zweiten Kunststoff versehen sind, untereinander verbunden, so daß die Bereiche und Verbindungsbereiche mittels eines einzigen Anspritzvorganges und über nur einen oder wenig mehr Anspritzpunkte mit dem zweiten Kunststoff versehen werden können.

Zusätzlich werden auch die Durchbrechungen des Gehäuses dichtend verschlossen, über die später von außen ein im Gehäuse befindlicher elektrischer Schalter und sonst ein mechanisches Betätigungsmittel einfach bedient werden kann. Mit dieser Maßnahme kann neben der Vibrations- und Schalldämmung ein absolut dichtes Haushaltsgerät geschaffen werden, wobei der zweite Kunststoff in seiner Härte so gering gewählt wird, daß er mit verhältnismäßig geringem Kraftaufwand leicht verformbar ist. Bei Verwendung eines elastischen zweiten Kunststoffes kann eine eine Durchbrechung verschließende Membran in radialer Richtung von Hand derart elastisch eingedrückt werden, daß hierdurch ein im Inneren des Gehäuses nahe der Membran liegendes Bauteil betätigt werden kann.

Dabei ist der zweite Bereich der Wand hinsichtlich der Form identisch mit der zugehörigen Durchbrechung und vollständig durch den zweiten Kunststoff gebildet, so daß die vom Rand der Durchbrechung begrenzten und an ihr dichtend gehaltene Membran entsteht, die nach außen die Durchbrechung vollständig verschließt. Es ist aber auch denkbar, daß die Membran eine Öffnung aufweist, durch die dann ein im Gehäuse angeordnetes Bedienteil nach außen ragt, was dann seinerseits dichtend von der Öffnung umschlossen wird. Im inneren Bereich kann die Membran dünner als die normale, feste Wand des Gehäuses ausgebildet sein, wodurch ihre Flexibilität erhöht wird.

Von Vorteil sind die an der Innenfläche der Wand ausgebildeten Verbindungsbereiche als die Innenfläche wenigstens teilweise bedeckende Schicht ausgebildet. Der speziellen Formgebung der Verbindungsbereiche sind kaum Grenzen gesetzt. Diese Formgebung kann an die speziellen Erfordernisse angepaßt werden. Auch können diese Verbindungsbereiche, die mit dem zweiten Kunststoff bedeckt sind, neben den ersten Bereichen zur Schalldämmung dienen und Geräusche, beispielsweise eines Motors oder Getriebes, abschwächen, so daß diese gedämpft nach außen dringen. Auch kann die Dicke der die Innenfläche bedeckenden Schicht des zweiten Kunststoffs variabel sein, so daß beim Einsatz eines elastischen, zweiten Kunststoffs die Verbindungsbereiche, beispielsweise als Federlement, zum elastischen Abstützen von Einbauteilen dienen. Auch können diese Verbindungsbereiche zum Ausgleich von Toleranzen und Wärmedehnungen je nach Einsatzzweck speziell gestaltet werden.

Der zweite, elastische Kunststoff dient unter anderem nicht nur als schwingungsdämpfendes, haltendes und optisches Mittel sondern auch als dichtendes Mittel. Anstelle der Membran kann auch in die dann nur zu Montagezwecken dienende Durchbrechung ein Stopfen eingespritzt werden, der dann nur eine Dichtfunktion übernimmt. Dadurch, daß die Membran über Verbindungsbereiche mit den Anlagebereichen verbunden ist, können diese beim Anspritzen des zweiten Kunststoffes an das Gehäuse besonders einfach in einem Arbeitsgang ausgeformt werden. Die Durchbrechungen dienen dabei auch als Überleitung des zweiten Kunststoffs von der Innenfläche zur Außenfläche des Gehäuses. Es ist aber auch durchaus denkbar, daß die Überleitung des zweiten Kunststoffes von der Innenfläche zur Außenfläche des Gehäuses an seinen Stirnflächen erfolgt.

Durch die Merkmale des Patentanspruchs 2 lassen sich die einzelnen Betätigungsflächen am zweiten Kunststoff besonders einfach kennzeichnen, so daß eine Bedienungsperson besonders leicht den richtigen Betätigungs- bzw. Druckpunkt findet. Dies kann insbesondere noch durch einen erhöhten Haftwert des zweiten Kunststoffes verstärkt werden, wodurch dieser Punkt leichter abtastbar ist.

Durch die Weiterbildung der Merkmale des Patentanspruchs 3 können auch neben einer eine Durchbrechung verschließende Membran oder Stopfen weitere Bereiche an der Außenfläche des Gehäuses mit dem zweiten Kunststoff versehen sein, wodurch beispielsweise eine bessere Handhabung und Griffestigkeit eines Gerätes erzielt werden kann. Dieser dritte Bereich kann durch seine Formgebung, Farbe, Rauhigkeit dabei auch noch zur äußeren Gestaltung des Gehäuses beitragen.

Gemäß den Merkmalen des Anspruchs 4 wird der dritte Bereich durch höher- oder tiefergesetzte Berührungsfläche ebenfalls besser hervorgehoben, bzw. er ist leichter auffindbar.

Durch die Merkmale des Patentanspruchs 5 ergibt sich eine besonders große zusammenhängende Anbindungsfläche des zweiten Kunststoffs an den ersten Kunststoff, so daß die Haltbarkeit der Membran im Übergangsbereich erhöht wird.

Gemäß den Merkmalen des Patentanspruchs 6 wird der zweite Kunststoff in eine Nut, Sicke oder dergleichen eingebracht, wodurch insbesondere an der Außenfläche angespritzte Griffleisten angeordnet sein können, die dann einerseits nicht über die Außenfläche des mit dem ersten Kunststoff versehenen Gehäuses hervorstehen müssen und durch die andererseits beispielsweise die Griffigkeit des Gehäuses verbessert werden kann. Hierzu wird der zweite Kunststoff eingesetzt, der bevorzugt einen höheren Reibwert bei geringerer Härte als der erste Kunststoff aufweist. Weist dabei noch der zweite Kunststoff eine andere Farbe als der erste Kunststoff auf, so können Bereiche ästhetischer oder informativer Funktion geschaffen werden, beispielsweise Bereiche mit Symbolen, Handhabungsanweisungen oder Bereiche mit anderem Design. Die Oberseite des zweiten Kunststoffes kann dabei die Außenfläche des Gehäuses überragen oder sie kann innerhalb der Nut, also unterhalb der Außenfläche des Gehäuses, liegen.

Gemäß den Merkmalen des Patentanspruchs 7 können derartige Verdickungen oder Erhebungen als Auflagepunkte zum Ablegen des Gerätes des persönlichen Bedarfs dienen. Sofern der zweite Kunststoff weich ist, kann ein geräuschloses und schonendes Ablegen des Gerätes über die Verdickungen gewährleistet werden. Hat der zweite Kunststoff beispielsweise einen hohen Reibwert, so ist das Gerät auch noch gegen Verschieben und Abrutschen auf bzw. von der Unterlage gesichert.

Gemäß der Weiterbildung nach den Merkmalen des Patentanspruchs 8 können auch an den Stirnseiten des Gehäuses Anlageflächen mit dem zweiten Kunststoff angespritzt werden, die mit entsprechend gleichen Gegenflächen eines weiteren Gehäuses eine dichte Einheit bilden. Dieser vierte Bereich vermeidet zusätzliche Dichtungen zwischen zwei Gehäuseteilen und vereinfacht zudem noch die Montage.

Gemäß den Merkmalen des Patentanspruchs 9 wird eine besonders innige und gut haftende Verbindung zwischen dem ersten und zweiten Kunststoff erreicht. Die Merkmale des Patentanspruchs 10 stellen ein Verkleben in Verbindung mit einem Verschmelzen des ersten mit dem zweiten Kunststoff im Oberflächenbereich dar. Diese Verbindung ist nicht nur dauerhaft fest, sondern sie ist auch absolut dicht. Dabei ist der thermoplastische Elastomer so flüssig,daß er in die zur Aufspritzung vorgesehenen Bereiche einfließt, sich innig mit dem ersten Kunststoff verbindet und anschließend bei Abkühlung aushärtet.

Ein Ausführungsbeispiel der Erfindung ist in der Zeichnung dargestellt und wird im folgenden näher erläutert. Es zeigen:
- Fig. 1: Längsschnitt durch ein Gehäuse nach der Erfindung,
- Fig. 2: Längsschnitt gemäß der Schnittführung II-II nach Fig. 1,
- Fig. 3: Schnitt quer zur Längsrichtung des Gehäuses gemäß der Schnittführung III-III nach Fig. 1 und
- Fig. 4: Schnitt quer zur Längsrichtung des Gehäuses gemäß der Schnittführung IV-IV nach Fig. 1.

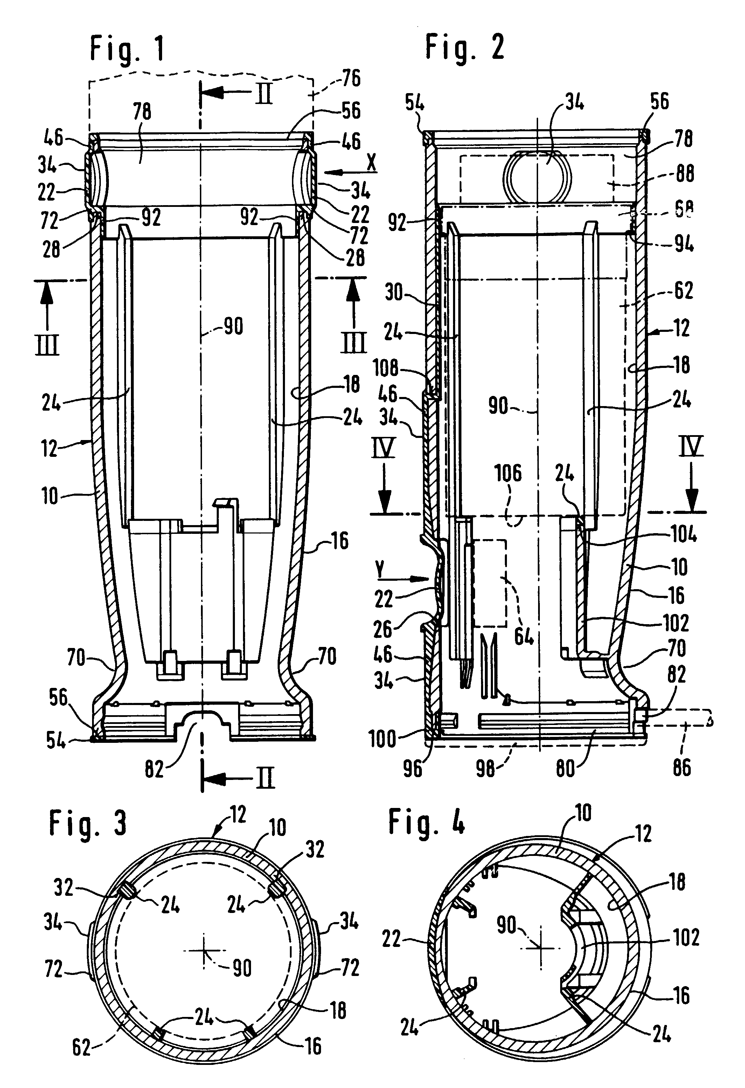

In den Figuren 1 bis 4 ist ein sich in seiner Länge kreiszylindrisch erstreckendes Gehäuse 12 dargestellt, das zur Aufnahme und Lagerung eines Elektromotors 62 dient, der in den Figuren 2 und 3 aber lediglich nur gestrichelt dargestellt ist, da dieser nicht Bestandteil des Gehäuses 12 ist. An den Elektromotor 62 schließt sich nach oben ein Getriebe 68 an, das in Fig. 2 nur strichpunktiert dargestellt ist. Das Getriebe 68 weist eine in der Zeichnung nicht dargestellte Kupplungseinrichtung auf, die mit einer Antriebswelle eines Arbeitswerkzeuges (nicht dargestellt) kuppelbar ist.

Das in den Figuren 1 und 2 dargestellte Gehäuse 12 ist auf den Kopf gestellt, so daß die Öffnung 78 im oberen Bereich als Anschluß für den mit einem Arbeitswerkzeug versehenen Schaft 76 eines Stabmixers dient, während die im unteren Bereich ausgebildete Öffnung 80 zum Aufsetzen eines Deckels 98 dient, der das Gehäuse 12 von dieser Seite her verschließt. Ein seitlich sich an die Öffnung 80 anschließender Durchlaß 82 dient als Ausgang für ein an das Gehäuse anzuschließendes Elektrokabel 86 (gestrichelt dargestellt).

Aus der DE-A-24 29 056 ist ein Stabmixer bekannt, so daß dessen Aufbau grundsätzlich auch auf das in den Figuren 1 bis 4 dargestellte Gehäuse angewendet werden kann. Allerdings ist das Gehäuse 12 nach der Erfindung einteilig ausgebildet, so daß zum Zwecke der im Gehäuse 12 einzusetzenden Bauteile, wie Elektromotor 62, Getriebe 68, elektrischer Schalter 64, Kabel 86 und Entriegelungseinrichtung 88 dieses von oben über die Öffnung 78 und von unten über die Öffnung 80 zugänglich ist.

Das Gehäuse 12 weist eine kreiszylindrisch verlaufende Wand 10 mit einer Außenfläche 16 und mit einer Innenfläche 18 auf. Im unteren Bereich ist am Gehäuse 12 eine Griffmulde 70 ausgebildet, die zum Halten und Führen des Stabmixers während des Betriebs dient. Die Wand 10 besteht aus einem ersten, bevorzugt festen Kunststoff, wie beispielsweise Polypropylen, der in den Zeichnungen einfach schraffiert dargestellt ist. Das Gehäuse 12 weist weiterhin Bereiche 22, 24, 46, 54 auf, die mit einem zweiten Kunststoff, vorzugsweise einem der molekularen Struktur des Polypropylen angepaßten thermoplastischen Elastomer, heiß angespritzt ist, dieser zweite Kunststoff wurde in der Zeichnung an den entsprechenden Stellen gekreuzt schraffiert dargestellt. Der zweite Kunststoff weist eine andere Eigenschaft, z.B. eine andere Farbe, eine andere Härte oder einen anderen Reibwert als der erste Kunststoff auf.

An der Innenfläche 18 des Gehäuses 12 sind im oberen Bereich längs der Mittellinie 90 verlaufende Vertiefungen 32 in Form von Nuten eingeformt, in die der zweite Kunststoff als erster Bereich 24 in Form von Rippen angespritzt ist. Die Rippen 24 ragen über die Innenfläche 18 radial nach innen hervor, die als Anlagebereiche 24 für den Elektromotor 62 dienen. Den beiden oberen Rippen 24 gegenüberliegend sind nach Fig. 3 im unteren Bereich zwei weitere Rippen 24 direkt an der Innenfläche 18 angespritzt und stehen ebenfalls radial nach innen soweit hervor, daß ihre Anlagebereiche 24 mit Vorspannung an der Außenfläche des Elektromotors 62 anliegen. Wie also aus Fig. 3 deutlich hervorgeht, können die Anlagebereiche 24 entweder in als Nuten oder Sicken ausgebildeten Vertiefungen 32 oder direkt auf die Oberfläche, was hier die Innenfläche 18 ist, aufgespritzt werden.

Nach den Figuren 1 und 2 sind an der oberen Öffnung 78 an der Wand 10 des Gehäuses 12 diametral gegenüberliegend Durchbrechungen 28 in Form von Bohrungen ausgebildet, die ebenfalls von dem zweiten Kunststoff als zweiter Bereich 22 überspannt sind und somit die Durchbrechung 28 dichtend verschließen. Der zweite Bereich 22 weist eine je kreisförmige Verdickung 72 auf, deren Außenseite als Griffläche 34 dient. Der zweite Bereich 22 ist so innig mit dem Rand der Durchbrechung 28 rundum verbunden, daß dieser eine flexible Membran ergibt, die, wenn man von außen in Richtung X mit der Hand beaufschlagt, sich diese derart radial zur Mittellinie 90 hin verformt, daß die an der Entriegelungseinrichtung 88 (gestrichelt dargestellt) ausgebildeten Betätigungsschieber (nicht dargestellt) verschoben werden können, wodurch der mit dem Arbeitswerkzeug versehene Schaft vom Motorgehäuse 12 getrennt werden kann. Letztere Teile sind aber hier nicht dargestellt.

Der zweite Bereich 22 ist noch von einem dritten Bereich 46 umgeben und einstückig zusammenhängend mit diesem verbunden. Geringfügig unterhalb des zweiten Bereichs 22 verläuft dieser noch an der Innenwandung 18 als verdickter Ringwulst 92, der als druckdichte Anlage und Zentrierung für das Getriebe 68 dient, das sich in diesem Bereich über die Ringstufe 94 im Durchmesser geringfügig vergrößert.

Am Gehäuse sind die zwei diametral gegenüberliegenden Grifflächen 34 mit dem sie umgebenden dritten Bereich 46 angeordnet, wobei der dritte Bereich 46 auch die Stirnfläche 56 des Gehäuses 12 ringförmig bedeckt, so daß sich ein vierter Bereich 54 an dieser Stelle ergibt, der als Funktion einer Dichtlippe ebenfalls fest mit der Stirnfläche 56 verbunden ist.

Nach Fig. 2 ist, um 90° zu den Grifflächen 34 versetzt, im linken unteren Bereich der Wand 10 eine weitere Durchbrechung 26 ausgebildet, die ebenfalls von einem zweiten Bereich 22 verschlossen ist, der, wie bereits oben beschrieben, eine flexible Membran bildet, hinter der sich ein elektrischer Schalter 64 im Inneren des Gehäuses 12 befindet, der bei Betätigung der Membran in Richtung Y durch Verformung dieser betätigt wird.

Der zweite, erhabene Bereich 22 ist ebenfalls von dem dritten Bereich 46 umgeben, der aber nicht in Verbindung mit dem dritten Bereich 46 steht, welcher die Grifflächen 34 umgibt. Auch dieser dritte Bereich 46 ist einstückig zusammenhängend mit dem zweiten Bereich 22 verbunden. Auch hier ragt der dritte Bereich 46 über die untere Stirnkante 96 hinaus und bedeckt diese bis auf den Durchlaß 82 rundum. Zum Verschließen der Öffnung 80 dient ein Deckel 98, der aber in der Zeichnung nur gestrichelt dargestell ist und der dichtend an dem an der Stirnfläche 96 anliegenden Ringbereich 100 des zweiten Kunststoffs anliegt.

Wie aus den Figuren 2 und 4 weiterhin ersichtlich ist, sind im Inneren des Gehäuses 12 an der Wandung 10 Rippen bzw. Stege 102 angeformt, an deren zur Öffnung 78 hin gerichteten Stirnflächen 104 ebenfalls der zweite Kunststoff angespritzt ist, der auch den ersten Bereich 24 bildet und der über die Innenfläche 18 mit den als längs der Mittellinie 90 verlaufenden Rippen 24 einstückig zusammenhängend verbunden ist. Die an den Stirnflächen 104 ausgebildeten ersten Bereiche 24 dienen als Anlage für die am Elektromotor 62 ausgebildete untere Stirnfläche 106, so daß der Elektromotor 62 sowohl in axialer, als auch in radialer Richtung vibrationsfrei an den ersten Bereichen 24 anliegt und in dieser Lage ohne zusätzliche Befestigungsmittel reibschlüssig festgehalten wird. Durch diese Anordnung wird ein besonders leise und schwingungsarm laufendes Haushaltsgerät erreicht.

Nach Fig. 2 ist der zweite Bereich 22 über den dritten Bereich 46 mit einem an der Innenwandung 18 angespritzten Verbindungsbereich 30 verbunden, der wiederum die Verbindung zum Ringwulst 92 herstellt. Hierzu ist in der Wandung 10 des Gehäuses 12 eine Bohrung 108 ausgebildet, über die der zweite Kunststoff von der Innenfläche 18 zur Außenfläche 16 fließen kann. Nach der Erfindung können also alle Bereiche 22, 24, 46, 56 über Verbindungsbereiche 30 miteinander verbunden sein. Es ist aber im Sinne der Erfindung auch durchaus denkbar, daß der im oberen und unteren Bereich am Gehäuse 12 angespritzte zweite Kunststoff keine Verbindung zueinander hat.

Nachdem das Gehäuse 12 mit dem ersten Kunststoff ausgespritzt wurde, wird dieses Gehäuse 12 in ein zweites Spritzwerkzeug (nicht dargestellt) eingelegt, in dem an den Stellen, wo ein zweiter Kunststoff angespritzt werden soll, Hohlräume mit dem Gehäuse 12 gebildet sind. Nun wird ein auf 80° bis 90° C erwärmtes thermoplastisches Elastomer, das in diesem Zustand die Viskosität nahezu von Wasser hat, über spezielle Anspritzstellen in das Spritzwerkzeug (nicht dargestellt) eingespritzt, von wo dieses thermoplastische Elastomer in die Hohlräume einfließt und diese ausfüllt. Aufgrund der verhältnismäßig warmen Temperatur des Elastomers und der Tatsache, daß dieses thermoplastische Elastomer, mit der Handelsbezeichnung "Thermoflex" (TPE), in seinem molekularen Aufbau dem ersten Kunststoff, nämlich Polypropylen, entspricht, geht dieser thermoplastische Elastomer eine besonders innige Verbindung mit der Oberfläche des ersten Kunststoffes ein, so daß dieser förmlich auf der Oberfläche des ersten Kunststoffes vulkanisiert, verklebt bzw. nahezu mit dieser verschweißt. Nach Abkühlen des thermoplastischen Elastomers kann das Gehäuse 12 aus dem zweiten Spritzwerkzeug entnommen werden. Durch diesen zweiten Spritzvorgang entsteht ein besonders einfach herzustellendes, aber in seiner Funktion sehr vielseitiges Gehäuse.

## Patentansprüche

1. Gehäuse (12) für ein elektrisch betriebenes Gerät des persönlichen Bedarfs, wie Zahnbürste, Rasierapparat, Küchengerät oder -maschine und dergleichen zur Aufnahme von Antriebs-, Steuer- und Schalteinrichtungen (62, 88, 64), das aus einem ersten Kunststoff mit mindestens einer Außenfläche (16) und einer Innenfläche (18) besteht und das zumindest in einem Bereich (22, 24) mit wenigstens einem zweiten Kunststoff, dessen Härte geringer ist als die Härte des ersten Kunststoffes, versehen ist, wobei dieser erste Bereich (24) zumindest in einzelnen Abschnitten gegenüber der Innenfläche (18) der Wand (10) als Anlagebereiche (24), z.B. Leiste, Vorsprung oder Rippe, hervorsteht und wobei die Anlagebereiche (24) als Anlage von im Gehäuse (12) montierbarer Bauteile, wie Elektromotor (62) oder sonstiger separater Bauteile dienen,
**dadurch gekennzeichnet,**
daß an der Innenfläche (18) der Wand (10) des Gehäuses (12) der zweite Kunststoff derart angespritzt ist, daß der erste und zweite Kunststoff an ihren Verbindungsstellen eine innige Verbindung eingehen, daß von mindestens einem Bereich (24) mindestens ein ebenfalls vom zweiten Kunststoff gebildeter Verbindungsbereich (30) ausgeht, der in jeweils wenigstens eine Durchbrechung (26, 28) der Wand (10) mündet und daß die Durchbrechung (26, 28) der Wand (10) von dem zweiten Kunststoff in Form einer einen zweiten Bereich (22) bildenden Membran dichtend verschlossen ist.

2. Gehäuse nach Anspruch 1,
**dadurch gekennzeichnet,**
daß die Membran gegenüber der Außenfläche (16) des aus dem ersten Kunststoff bestehenden Gehäuse (12) erhaben oder vertieft angeordnet ist.

3. Gehäuse nach Anspruch 1,
**dadurch gekennzeichnet,**
daß auch an der Außenfläche (16) des Gehäuses (12) der zweite Kunststoff angespritzt ist, der einen dritten Bereich (46) bildet.

4. Gehäuse nach Anspruch 3,
**dadurch gekennzeichnet**,
daß in dem dritten Bereich (46) der Außenfläche (16) der zweite Kunststoff als gegenüber der Außenfläche (16) hervor- oder tieferstehende Griffläche (34) aufgebracht ist.

5. Gehäuse nach Anspruch 3,
**dadurch gekennzeichnet**,
daß der dritte Bereich (46) den zweiten Bereich (24) rundum umgibt und einstückig zusammenhängend mit diesem verbunden ist.

6. Gehäuse nach Anspruch 1 und 3,
**dadurch gekennzeichnet**,
daß der zweite Kunststoff des ersten und dritten Bereiches (24 und 46) in an der Innen- bzw. Außenfläche (18 bzw. 16) angeformten Vertiefungen (32), z.B. eine Nut, Sicke oder dergleichen, eingespritzt ist.

7. Gehäuse nach Anspruch 3,
**dadurch gekennzeichnet**,
daß am dritten Bereich (46) an der Außenfläche (16) eine Verdickung oder Erhebung (72) angebracht ist.

8. Gehäuse nach Anspruch 1,
**dadurch gekennzeichnet**,
daß an der Stirnfläche (56) des stirnseitigen Endes des Gehäuses (12) ein vierter Bereich (54) des zweiten Kunststoffes in Form einer Leiste angespritzt ist, die als dichtende Anlage für ein weiteres Gehäuseteil (98, 76) dient.

9. Gehäuse nach einem der vorhergehenden Ansprüche,
**dadurch gekennzeichnet**,
daß der erste und zweite Kunststoff durch Verschmelzen, Versintern oder dergleichen miteinander verbunden sind.

10. Gehäuse nach Anspruch 1,
**dadurch gekennzeichnet,**
daß der erste Kunststoff des Gehäuses (12) aus Polypropylen (PP) und der zweite Kunststoff aus einem in seiner molekularen Struktur dem Polypropylen entsprechenden thermoplastischen Elastomer, vorzugsweise Thermoflex oder Thermoplast (TPE), besteht und daß der thermoplastische Elastomer mit einer Temperatur von etwa 70° bis 130° C, vorzugsweise 80° bis 90° C, auf Teilbereiche der Oberfläche (16, 18, 56) des Gehäuses (12) aufgespritzt wird.

## Claims

1. A housing (12) for an electrically powered appliance for personal use, such as a toothbrush, a shaving apparatus, a kitchen appliance or food processor and the like, for accommodating drive, control and switching devices (62, 88, 64), said housing being fabricated from a first plastic material having at least one outer surface (16) and one inner surface (18) and being provided in at least one area (22, 24) with at least one second plastic material of a hardness lower than the hardness of the first plastic material, said first area (24) projecting from the inner surface (18) of the wall (10) at least in individual sections, forming bearing areas (24) as in the form of strips, projections or rib members, and said bearing areas (24) serving as supports for components mountable in the interior of the housing (12), such as an electric motor (62) or other separate components,
**characterized in that** the second plastic material is molded onto the inner surface (18) of the wall (10) of the housing (12, such as to establish an intimate connection between the first and the second plastic material where they are joined together, that at least one connecting area (30) equally formed by the second plastic material extends from at least one area (24), said connecting area terminating in at least one aperture (26, 28) in the wall (10), and that the aperture (26, 28) in the wall (10) is closed tight by the second plastic material in the form of a diaphragm providing a second area (22).

2. A housing as claimed in claim 1,
**characterized in that** the diaphragm is arranged in a raised or recessed manner relative to the outer surface (16) of the housing (12) fabricated from the first plastic material.

3. A housing as claimed in claim 1,
**characterized in that**the second plastic material is also molded onto the outer surface (16) of the housing (12), providing a third area (46).

4. A housing as claimed in claim 3,
**characterized in that**in the third area (46) on the outer surface (16), the second plastic material is deposited as a gripping surface (34) arranged in a raised or recessed manner relative to the outer surface (16).

5. A housing as claimed in claim 3,
**characterized in that** the third area (46) surrounds the second area (22) all-round and is integrally formed therewith.

6. A housing as claimed in claim 1 and claim 3,
**characterized in that**the second plastic material of the first and third areas (24 and 46) is injected into recesses (32) as, for example, a groove, a bead or the like, that are formed on the inner and outer surface, respectively (18 and 16, respectively).

7. A housing as claimed in claim 3,
**characterized in that** a thickened or raised portion (72) is provided on the outer surface (16) in the third area (46).

8. A housing as claimed in claim 1,
**characterized in that** a fourth area (54) fabricated from the second plastic material in the form of a strip is molded onto the end (56) of the housing (12) to serve as a sealed bearing surface for a further housing part (98, 76).

9. A housing as claimed in any one of the preceding claims,
**characterized in that** the first and the second plastic material are connected with each other by blending, fusing together, or the like.

10. A housing as claimed in claim 1,
**characterized in that**the first plastic material of the housing (12) is polypropylene (PP), the second plastic material is a thermoplastic elastomer corresponding in its molecular structure to polypropylene, preferably Thermoflex or Thermoplast (TPE), and that the thermoplastic elastomer is injection-molded onto partial areas of the surface (16, 18, 56) of the housing (12) at a temperature in a range of about 70° C to 130° C, preferably 80° C to 90° C.

## Revendications

1. Boîtier (12) pour un appareil électrique à usage personnel, tel qu'une brosse à dent, un appareil à raser, un appareil ou une machine de cuisine et similaire, pour recevoir des dispositifs d'entraînement, de commande ou de commutation (62, 88, 64), qui est constitué en une première matière plastique présentant au moins une surface extérieure (16) et une surface intérieure (18), et qui est pourvu du moins dans une zone (22, 24) d'au moins une seconde matière plastique dont la dureté est inférieure à la dureté de la première matière plastique, dans lequel cette première zone (24) dépasse du moins dans des tronçons individuels par rapport à la surface intérieure (18) de la paroi (10) en tant que zones d'appui (24), par exemple sous forme d'une barrette, d'une saillie ou d'une nervure, et dans lequel les zones d'appui (24) servent d'appui à des composants susceptibles d'être montés dans le boîtier (12), tels que le moteur électrique (62) ou d'autres composants séparés, caractérisé en ce que la seconde matière plastique est injectée contre la surface intérieure (18) de la paroi (10) du boîtier (12), de telle sorte que la première matière plastique et la seconde matière plastique établissent une liaison intime au niveau de leurs emplacements de liaison, en ce qu'au moins une région de liaison (30) formée également par la seconde matière plastique part depuis au moins une zone (24) et débouche respectivement dans au moins une traversée (26, 28) de la paroi (10), et en ce que la traversée (26, 28) de la paroi (10) est refermée de façon étanche par la seconde matière plastique sous forme d'un diaphragme formant une seconde zone (22).

2. Boîtier selon la revendication 1, caractérisé en ce que le diaphragme est agencé en surélévation ou en renfoncement par rapport à la surface extérieure (16) du boîtier (12) constitué par la première matière plastique.

3. Boîtier selon la revendication 1, caractérisé en ce que la seconde matière plastique est également injectée sur la surface extérieure (16) du boîtier (12) et forme une troisième zone (46).

4. Boîtier selon la revendication 3, caractérisé en ce que dans la troisième zone (46) de la surface extérieure (16), la seconde matière plastique est appliquée sous forme d'une surface de saisie en surélévation ou renfoncement (34) par rapport à la surface extérieure (16).

5. Boîtier selon la revendication 3, caractérisé en ce que la troisième zone (46) entoure sur tout le tour la seconde zone (24) et est reliée en une seule pièce avec celle-ci.

6. Boîtier selon les revendication 1 et 3, caractérisé en ce que la seconde matière plastique de la première zone et de la troisième zone (24 et 46) est injectée dans des renfoncements (32), par exemple une gorge, une moulure ou similaire, moulés sur la surface intérieure ou extérieure (18 ou 16).

7. Boîtier selon la revendication 3, caractérisé en ce qu'il est prévu un épaississement ou une élévation (72) sur la troisième zone (46) sur la surface extérieure (16).

8. Boîtier selon la revendication 1, caractérisé en ce que sur la surface frontale (56) de l'extrémité côté frontal du boîtier (12), une quatrième zone (54) de la seconde matière plastique est injectée sous forme d'une barrette qui sert d'appui étanche pour une autre partie de boîtier (98, 76).

9. Boîtier selon l'une quelconque des revendications précédentes, caractérisé en ce que la première matière plastique et la seconde matière plastique sont reliées l'une à l'autre par fusion, par frittage ou similaire.

10. Boîtier selon la revendication 1, caractérisé en ce que la première matière plastique du boîtier (12) est constituée en polypropylène (PP) et la seconde matière plastique est constituée en un élastomère thermoplastique correspondant, quant à sa structure moléculaire, au polypropylène, de préférence en Thermoflex ou Thermoplast (TPE), et en ce que l'élastomère thermoplastique est injecté à une température d'environ 70° à 130°C, de préférence de 80° à 90°C, sur des régions partielles de la surface (16, 18, 56) du boîtier (12).
